# EUROPÄISCHE PATENTSCHRIFT

(11) **EP 2 672 579 B1**
(45) Veröffentlichungstag und Bekanntmachung des Hinweises auf die Patenterteilung: **04.10.2017**
(21) Anmeldenummer: 13168846.7
(22) Anmeldetag: 23.05.2013
(51) Int. Cl.: H01R 43/02

(54) **Verfahren zur elektrischen Kontaktierung eines Aluminiumdrahts**
Method for electrical connection of an aluminium wire
Procédé de connexion électrique d'un fil d'aluminium

(30) Priorität: 06.06.2012 DE 102012011184; 14.05.2013 DE 102013104933
(43) Veröffentlichungstag der Anmeldung: 11.12.2013
(73) Patentinhaber: Hanning Elektro-Werke GmbH & Co. KG, 33813 Oerlinghausen (DE)
(72) Erfinder: Buchalla, Harald, 59494 Soest (DE); Meyer, Christian, 49214 Bad Rothenfelde (DE)
(74) Vertreter: Wickord, Wiro

(56) Entgegenhaltungen:
- DE-A1-102009 059 307
- US-A1- 2012 085 040

## Beschreibung

Die Erfindung betrifft ein Verfahren zur elektrischen Kontaktierung nach dem Oberbegriff des Patentanspruchs 1.

Über lange Jahre wurden vorwiegend Kupferdrähte zur Herstellung von Spulen und Wicklungen von Elektromotoren verwendet. In jüngster Zeit kommen unter anderem aus Kostengründen Aluminiumdrähte zur Anwendung, insbesondere bei in hoher Stückzahl und unter großem Preisdruck gefertigten Produkten, beispielsweise bei Elektromotoren für den Bereich der weißen Ware (Pumpenantriebe für Geschirrspüler, Waschmaschinen etc.). Hierbei hat sich gezeigt, dass sich die Aluminiumdrähte - anders als Kupferdrähte - nicht gut, insbesondere nicht ausreichend reproduzierbar und zuverlässig, löten lassen. Entsprechend ist die elektrische Kontaktierung der Aluminiumdrähte mit dem für Kupferdrähte etablierten Lötverfahren problematisch. Stattdessen ist bekannt, Aluminiumdrähte auf einer Kontaktfläche (Substrat) Ultraschall zu bonden. Hierbei wird der Aluminiumdraht mit einer Anpresskraft gegen die Kontaktfläche gedrückt und unter Einwirkung von Ultraschall verschweißt. Verfahrenstechnisch ist hierbei die den Aluminiumdraht mantelseitig umgebende äußere Oxidschicht von Bedeutung. Die Oxidschicht bildet einen harten Reibpartner für die in der Regel ebene metallische Kontaktfläche und begünstigt so die Bondfähigkeit des Aluminiumdrahts.

Bei der Verwendung von Aluminiumdraht für Spulen beziehungsweise Motorwicklungen müssen die einzelnen Drahtwicklungen gegeneinander isoliert werden. Aus diesem Grund umgibt den Aluminiumdraht mantelseitig ein Isolierlack. In umfangreichen Vorversuchen hat sich gezeigt, dass der Isolierlack die Bondfähigkeit des Aluminiumdrahts stark negativ beeinflusst. Ein mit dem Isolierlack umzogener Aluminiumdraht kann mit dem bekannten Bondverfahren nicht ausreichend gut, insbesondere nicht reproduzierbar, zuverlässig und prozesssicher auf die Kontaktfläche gebondet werden.

Aus der US 2012/0085040 A1 ist ein elektrisches Verbindungssystem für Solaranlagen bekannt. Es kann hierbei vorgesehen sein, dass ein elektrisch isolierter Leiter durch ein einwirkendes Plasma jedenfalls in einer Sektion abisoliert wird.

Aus der DE 10 2009 059 307 A1 ist ein Verfahren zum elektrisch leitenden Kontaktieren von Drähten bekannt, bei dem ein mantelseitig isolierter Draht in einem ersten Schritt mittels Kunststoff-Ultraschallschweißens abisoliert und dann in einem zweiten Schritt mittels Metall-Ultraschallschweißens beziehungsweise Widerstandsschweißens stoffschlüssig kontaktiert wird.

Aufgabe der vorliegenden Erfindung ist es daher, ein Verfahren zum zumindest lokalen Entfernen des Isolierlacks von dem Aluminiumdraht bereitzustellen, welches prozesssicher anwendbar und kostengünstig durchführbar ist.

In einer großen Vielzahl von Versuchsreihen wurde seitens der Anmelderin zunächst versucht, den Isolierlack mechanisch vom Aluminiumdraht zu entfernen. Hierbei zeigte sich, dass regelmäßig neben dem Isolierlack auch die äußere Oxidschicht des Aluminiumdrahts entfernt oder zumindest geschädigt wurde. Infolge der Schädigung der Oxidschicht ließ sich anschließend der Aluminiumdraht weniger gut bonden. Zwar regeneriert die Oxidschicht selbsttätig, wenn sie entfernt oder beschädigt wurde. Jedoch ist die hierzu erforderliche Zeit unter Prozessgesichtspunkten nachteilig.

Weiter wurde versucht, den Isolierlack thermisch zu entfernen. Aufgrund des geringen Durchmessers und der entsprechend geringen Wärmekapazität des Drahtes ist eine prozesssichere Wärmebehandlung äußerst problematisch. Am Draht können dabei Temperaturen entstehen, die - insbesondere bezogen auf die Schmelztemperatur von Aluminium - als kritisch anzusehen sind. Infolge der Wärmebehandlungen können demzufolge das Gefüge des Aluminiumdrahts verändert und die Dauerfestigkeit der Kontaktierung in Frage stellen werden.

Zur Lösung der Aufgabe weist die Erfindung die Merkmale des Patentanspruchs 1 auf.

Der besondere Vorteil der Erfindung besteht darin, dass beim Abisolieren des Aluminiumdrahtabschnitts mithilfe eines elektrischen Plasmas weder die Oxidschicht des Aluminiumdrahts unzulässig beschädigt noch das Gefüge des Aluminiumdrahts in der Art verändert wird, dass sich negative Effekte, insbesondere hinsichtlich der Langzeitstabilität der Bondverbindung, gezeigt haben. Insofern lassen sich durch die Verwendung des Plasmas insbesondere optisch nicht in einfacher Weise erkennbare Schädigungen, beispielsweise nachteilige Gefügeänderungen vermeiden. Durch die Plasmabehandlung wird gezielt der Isolierlack abgetragen, ohne dass die Bondfähigkeit beziehungsweise mechanische Stabilität des Aluminiumdrahts beziehungsweise die Oxidschicht unzulässig negativ beeinträchtigt werden. Zudem hat sich gezeigt, dass der Verfahrensschritt prozesssicher, das heißt reproduzierbar und automatisierbar ist. Die Aluminiumdrähte werden insbesondere im Bereich der weißen Ware für Spulen von Transformatoren oder Motorwicklungen für Elektromotoren oder andere elektromagnetische Antrieben eingesetzt. Besonders vorteilhaft lässt sich das erfindungsgemäße Verfahren bei Aluminiumdrähten mit Durchmessern von 0,1 bis 0,7 mm anwenden.

Unter einem elektrischen Plasma im Sinne der Erfindung wird jedes Gas verstanden, das freie Ladungsträger (Ionen, Elektronen und/oder geladene Moleküle) aufweist. Das Plasma kann als ein Gemisch aus neutralen und geladenen Teilchen gebildet sein oder ausschließlich geladene Teilchen enthalten. Vorzugsweise wird ein sogenanntes "Normaldruck- oder Athmosphärendruckplasma" verwendet.

Hinsichtlich der Temperatur wird das elektrische Plasma so eingestellt, dass es einerseits warm genug ist, um die Lackschicht auf dem Draht beziehungsweise der Oxidschicht vollständig oder in Teilen zu schmelzen, und dass es andererseits den Draht nicht verbrennt beziehungsweise nicht zu nachteiligen Struktur- bzw. Gefügeänderungen kommt. Verschiedene Versuche haben gezeigt, dass ein zufriedenstellendes Ergebnis insbesondere im Temperaturbereich von 200°C bis unterhalb von 620°C erreicht wird. Je nach Temperatur ist unter Berücksichtigung der Drahtgeometrie die Prozesszeit so zu wählen, dass eine unzulässige Schädigung des Aluminiumdrahtabschnitts nicht erfolgt.

Nach einer bevorzugten Ausführungsform der Erfindung wird in einem Taktbetrieb zunächst der Aluminiumdrahtabschnitt abisoliert und danach der Aluminiumdraht Ultraschall gebondet. Vorteilhaft kann durch die Realisierung eines Taktbetriebs die Automatisierbarkeit des Verfahrens verbessert und der Durchsatz erhöht werden. Insbesondere können eine erste Prozesszeit für das Abisolieren des Aluminiumdrahtabschnitts und eine zweite Prozesszeit für das Ultraschallbonden des Aluminiumdrahts so aufeinander abgestimmt werden, dass eine hohe Auslastung insbesondere des Bondautomaten gewährleistet wird. Der Taktbetrieb verbessert somit insbesondere auch die Wirtschaftlichkeit des Kontaktierungsverfahrens.

Nach einer Weiterbildung der Erfindung ist eine Taktzeit kleiner als 10 Sekunden, bevorzugt kleiner als 1 Sekunde und besonders bevorzugt kleiner als 0,5 Sekunden. Vorteilhaft resultiert eine geringe Taktzeit in einem hohen Durchsatz. Zur Realisierung der genannten Taktzeiten können insbesondere gleichzeitig mehrere Aluminiumdrahtabschnitte abisoliert werden. Hierdurch wird ausgeglichen, dass der Verfahrensschritt des Abisolierens eine längere Zeitdauer beansprucht als der Bondvorgang, das heißt dass die erste Prozesszeit größer ist als die zweite Prozesszeit. Aus dem Verhältnis der Zeitdauer des Abisolierens zur Bondzeit (inklusive der Nebenzeiten für das Drahthandling, Positionieren des Bondkopfes etc.) kann die Anzahl parallel abzuisolierender Aluminiumdrahtabschnitte bestimmt werden.

Nach einer Weiterbildung der Erfindung wird der Aluminiumdrahtabschnitt zunächst abisoliert und in unmittelbarer zeitlicher Nähe dann der Aluminiumdraht auf die Kontaktfläche gebondet. Vorzugsweise liegen weniger als 300 Sekunden, insbesondere weniger als 30 Sekunden zwischen dem Ende des Abisolierens und dem Verbonden. Vorteilhaft verbessert sich hierdurch die Wirtschaftlichkeit des Verfahrens, da ein zwischenzeitliches Lagern des Aluminiumdrahts entbehrlich ist. Insbesondere können beide Verfahrensschritte in einer gemeinsamen Anlage beziehungsweise von einem einzigen Automaten durchgeführt werden.

Typischerweise wird der abisolierte Aluminiumdrahtabschnitt mit einer Kontaktfläche, beispielsweise der Kontaktfläche eines Steckers, verbondet. Der entsprechende Aluminiumdrahtabschnitt kann an der Kontaktfläche selbst positioniert und vorfixiert werden. Beispielsweise kann hierfür an dem Stecker eine Nase, eine Ausnehmung oder dergleichen vorgesehen werden. Vorteilhaft kann der Draht mittels des elektrischen Plasmas abisoliert werden, nachdem der Aluminiumdrahtabschnitt an dem Kontakt bzw. dem Stecker festgelegt ist. Die Bondfläche dient dann als Spiegel bzw. Prallfläche für das elektrische Plasma einerseits und zum Wärmeableiten andererseits. Beispielsweise kann die Kontaktstelle zur Vorbereitung des Bondens vorbehandelt werden. Eventuell kann eine entsprechend harte Beschichtung an der Kontaktfläche vorgesehen werden, welche den Bondprozess begünstigt.

Nach einer Weiterbildung der Erfindung werden in einem Verfahrensschritt zwei Aluminiumdrahtabschnitte eines Aluminiumdrahts beziehungsweise eine Mehrzahl von Aluminiumdrahtabschnitten verschiedener Wicklungsdrähte abisoliert. Vorteilhaft können hierdurch die zwei freien Drahtenden einer Spule beziehungsweise Wicklung oder die Mehrzahl von Aluminiumdrahtabschnitten verschiedener Wicklungsdrähte in zeitlicher Nähe kontaktiert werden. Beispielsweise wird eine Wicklung eines Elektromotors kontaktiert, indem sequentiell zunächst ein erstes freies Drahtende der Wicklung und anschließend ein zweites freies Drahtende der Wicklung gebondet werden. Die beiden Drahtenden werden hierzu zuvor abisoliert. Das Abisolieren erfolgt dabei vorzugsweise gleichzeitig.

Nach einer Weiterbildung der Erfindung wird der Aluminiumdraht während des Abisolierens des Aluminiumdrahtabschnitts bewegt. Insbesondere kann der Aluminiumdraht während des Abisolierens einem Bondwerkzeug zugeführt werden. Vorteilhaft reduziert sich hierdurch die Bearbeitungszeit für einen einzelnen Aluminiumdrahtabschnitt, da der Vorgang des Abisolierens und des Transportierens parallelisiert werden. Insbesondere kann der Aluminiumdraht während des Abisolierens dann besonders gut bewegt werden, wenn der Prozess des elektrochemischen Ätzens zumindest in erster Näherung von der exakten Position des Drahts im Plasma unabhängig ist.

Das Transportieren des Aluminiumdrahts während des Abisolierens ist auch von Vorteil, wenn das Abisolieren nach Art eines Durchlaufverfahrens realisiert wird, bei dem eine vorgegebene oder variable Anzahl von Aluminiumdrahtabschnitten zeitversetzt elektrochemisch behandelt wird zum Entfernen des Isolierlacks.

Nach einer Weiterbildung der Erfindung wird eine Einwirkzeit zum Abisolieren des Aluminiumdrahtabschnitts so gewählt, dass der an dem Aluminiumdrahtabschnitt ursprünglich vorgesehene Isolierlack zu wenigstens 50 %, bevorzugt zu wenigstens 75 % und besonders bevorzugt zu wenigstens 85 % entfernt wird, und/oder dass wenigstens 50 % einer Mantelseitenfläche des Aluminiumdrahtabschnitts, bevorzugt mehr als 75 % der Mantelseitenfläche des Aluminiumdrahtabschnitts und besonders bevorzugt mehr als 85 % der Mantelfläche des Aluminiumdrahtabschnitts vom Isolierlack befreit werden. Vorteilhaft wird durch das Entfernen des Isolierlacks zu wenigstens 50 % beziehungsweise durch das Freilegen der Mantelseitenfläche zu wenigstens 50 % eine ausreichende Kontaktierung während des anschließenden Bondens erreicht. Eventuell verbleibender Isolierlack beeinflusst den Bondvorgang demzufolge nicht so nachteilig, dass die Prozesssicherheit infrage steht oder die elektrische Kontaktierung nicht gewährleistet werden kann. Versuche haben gezeigt, ein Entfernen des Isolierlacks zu wenigstens 75 % beziehungsweise ein Freilegen der Mantelseitenfläche zu wenigstens 75 % sowohl die Prozesssicherheit als auch die elektrische Kontaktierfähigkeit weiter begünstigen. Tendenziell gilt, dass ein Mehr an freigelegter Mantelseitenfläche und ein Weniger an Isolierlack die Bondfähigkeit und die elektrische Kontaktierbarkeit begünstigen. Vor diesem Hintergrund ist zu verstehen, dass besonders gute Ergebnisse erzielt werden, wenn der Isolierlack vollständig entfernt beziehungsweise der Aluminiumdrahtabschnitt vollständig freigelegt wird.

Nach einer Weiterbildung der Erfindung wird die erste Prozesszeit für unterschiedliche Aluminiumdrähte und/oder unterschiedliche Isolierlacke und insbesondere die Einwirkzeit des elektrischen Plasmas auf den Aluminiumdrahtabschnitt in orientierenden Vorversuchen ermittelt und dann im Produktivbetrieb fest vorgegeben. Indem die Einwirkzeit für den konkret zu verarbeitenden Aluminiumdraht und den hierauf vorgesehenen Isolierlack im Vorfeld bestimmt wird, kann der Produktivbetrieb besonders einfach gestaltet werden. Insbesondere ergibt sich eine feste Taktzeit, wenn die Einwirkzeit zum Abisolieren des Aluminiumdrahtabschnitts im Vorfeld festgelegt ist. Hinsichtlich der Automatisierbarkeit des Verfahrens ist dies vorteilhaft.

Nach einer Weiterbildung der Erfindung wird während des Abisolierens des Aluminiumdrahtabschnitts ein Lackabtrag ermittelt und unter Berücksichtigung des Lackabtrags beziehungsweise einer aus dem Lackabtrag und der bisherigen Einwirkzeit bestimmten Lackabtragrate die verbleibende Einwirkzeit bestimmt beziehungsweise ein Beendigungssignal für das Abisolieren des Aluminiumdrahtabschnitts generiert. Vorteilhaft kann durch die variable Bestimmung der Einwirkzeit beziehungsweise die individuelle Generierung des Beendigungssignals für das Abisolieren ein hohes Maß an Prozesssicherheit erreicht werden. Sofern festgestellt wird, dass noch nicht ausreichend viel Isolierlack abgetragen wurde beziehungsweise ein nur unzureichender Anteil der Mantelseitenfläche freigelegt ist, wird der Vorgang des Abisolierens fortgesetzt. Beispielsweise kann die Abtragrate durch die Überwachung elektrischer beziehungsweise chemischer Prozessparameter, durch eine Gewichtsermittlung oder durch Bild gebende Sensoren bestimmt werden.

Nach einer Weiterbildung der Erfindung wird eine von dem Aluminiumdraht und der Kontaktfläche gebildeter Kontaktstelle mit einer Versiegelung überzogen. Die Versiegelung schützt die Kontaktstelle vor mechanischen und chemischen Einflüssen von außen. Die Versiegelung kann aus jedem geeigneten Material, beispielsweise aus einem Lack, einem Klebstoff oder einem Kunstharz gebildet sein. Die Versiegelung kann als eine selbstaushärtende Umhüllung realisiert werden. Ebenso kann die Aushärtung unter Einwirkung eines Aktivierungsmediums, beispielsweise UV-Licht, erfolgen. Wird zur Versiegelung ein Lack verwendet, kann dieser beispielsweise aufgesprüht beziehungsweise gestrichen werden. Der Auftrag eines Klebstoffs erfolgt vorteilhaft durch Verstreichen beziehungsweise Auftropfen. Sowohl der Lack als auch der Klebstoff können UV-härtbar ausgeführt sein. Insofern wird nach dem Auftragen des Lacks beziehungsweise des Klebstoffs die Versiegelung durch UV-Licht gehärtet. Zur Versiegelung kann weiter ein Verguss aufgetragen werden, beispielsweise ein 2-Komponenten-Verguss. Beim Aufbringen des Vergusses kann mit oder ohne Tasche zum Formen des Vergusses gearbeitet werden. Beispielsweise kann einzig die Kontaktstelle versiegelt werden. Ebenso kann das komplette Wicklungssystem versiegelt, insbesondere kunststoffumhüllt werden.

## Patentansprüche

1. Verfahren zur elektrischen Kontaktierung eines Aluminiumdrahts auf einer Kontaktfläche, wobei der an seiner Mantelfläche eine Oxidschicht aufweisende Aluminiumdraht mit einem Isolierlack ummantelt ist und mit der Kontaktfläche ultraschallverbondet wird und wobei vor dem Ultraschallbonden ein zur Herstellung der elektrischen Kontaktierung an der Kontaktfläche anzulegender Aluminiumdrahtabschnitt abisoliert wird,
**dadurch gekennzeichnet, dass** der den Draht mit der Oxidschicht mantelseitig umgebende Isolierlack unter Einwirkung eines elektrischen Plasmas abgetragen wird.

2. Verfahren nach Anspruch 1,
**dadurch gekennzeichnet, dass**
das elektrische Plasma definiert temperiert wird und dass das elektrische Plasma bevorzugt eine Temperatur von mehr als 200 °C und weniger als 620 °C aufweist.

3. Verfahren nach Anspruch 1 oder 2,
**dadurch gekennzeichnet, dass**
in einem Taktbetrieb zunächst der Aluminiumdrahtabschnitt abisoliert und danach der Aluminiumdraht ultraschallgebondet wird.

4. Verfahren nach Anspruch 3, **dadurch gekennzeichnet, dass** eine Taktzeit kleiner ist als 10 Sekunden, bevorzugt kleiner ist als 1 Sekunde und besonders bevorzugt kleiner ist als 0,5 Sekunden

5. Verfahren nach einem der Ansprüche 1 bis 4,
**dadurch gekennzeichnet, dass**
das Abisolieren des Aluminiumdrahtabschnitts und das anschließende Bonden des Aluminiumdrahts zeitlich unmittelbar aufeinander folgend durchgeführt werden, wobei insbesondere weniger als 300 Sekunden, bevorzugt weniger als 30 Sekunden zwischen der Beendigung des Abisolierens des Aluminiumdrahtabschnitts und der Zuführung des Aluminiumdrahts zum Ultraschallbonden liegen.

6. Verfahren nach einem der Ansprüche 1 bis 5,
**dadurch gekennzeichnet, dass**
zeitgleich der Isolierlack von einer Mehrzahl von Aluminiumdrahtabschnitten abgetragen wird.

7. Verfahren nach einem der Ansprüche 1 bis 6,
**dadurch gekennzeichnet, dass**
zeitgleich zwei Aluminiumdrahtabschnitte eines Aluminiumdrahts abisoliert werden.

8. Verfahren nach einem der Ansprüche 1 bis 7,
**dadurch gekennzeichnet, dass**
der Aluminiumdraht während des Abisolierens des Aluminiumdrahtabschnitts bewegt und insbesondere einem Bondwerkzeug zugeführt wird.

9. Verfahren nach einem der Ansprüche 1 bis 8,
**dadurch gekennzeichnet, dass**
eine Einwirkzeit zum Abisolieren des Aluminiumdrahtabschnitts so gewählt wird, dass der an dem Aluminiumdrahtabschnitt ursprünglich vorgesehene Isolierlack zu wenigstens 50 %, bevorzugt zu wenigstens 75 % und besonders bevorzugt zu wenigstens 85 % entfernt wird, und/oder dass wenigstens 50 % einer Mantelseitenfläche des Aluminiumdrahtabschnitts, bevorzugt mehr als 75 % der Mantelseitenfläche des Aluminiumdrahtabschnitts und besonders bevorzugt mehr als 85 % der Mantelfläche des Aluminiumdrahtabschnitts vom Isolierlack befreit wird.

10. Verfahren nach einem der Ansprüche 1 bis 9,
**dadurch gekennzeichnet, dass**
die Einwirkzeit für unterschiedliche Aluminiumdrähte und/oder unterschiedliche Isolierlacke in orientierenden Vorversuchen ermittelt wird und dann im Produktivbetrieb fest vorgegeben wird.

11. Verfahren nach einem der Ansprüche 1 bis 10,
**dadurch gekennzeichnet, dass**
während des Abisolierens des Aluminiumdrahtabschnitts ein Lackabtrag ermittelt wird und unter Berücksichtigung des Lackabtrags die verbleibende Einwirkzeit bestimmt und/oder ein Beendigungssignal für das Abisolieren des Aluminiumdrahtabschnitts generiert werden.

12. Verfahren nach einem der Ansprüche 1 bis 11,
**dadurch gekennzeichnet, dass**
ein von dem Aluminiumdraht und der Kontaktfläche gebildete Kontakt nach dem Ultraschallbonden versiegelt und insbesondere mit einer Umhüllung überzogen wird.

## Claims

1. Method for electrically contacting an aluminium wire on a contact face, the aluminium wire, which has an oxide layer on the outer surface thereof, being encased with an insulating varnish and being ultrasound-bonded to the contact face, and an aluminium wire portion which is to be applied to the contact face to establish the electrical contact being stripped of insulation prior to the ultrasound bonding,
**characterised in that**
the insulating varnish which encloses, on the outer face, the wire having the oxide layer is removed by the action of an electric plasma.

2. Method according to claim 1,
**characterised in that**
the electric plasma is temperature-controlled in a defined manner and **in that** the electric plasma preferably has a temperature of more than 200 °C and less than 620 °C.

3. Method according to either claim 1 or claim 2,
**characterised in that**
the aluminium wire portion is initially stripped of insulation and the aluminium wire is subsequently ultrasound-bonded, in a cycle operation.

4. Method according to claim 3,
**characterised in that**
a cycle time is less than 10 seconds, preferably less than 1 second and particularly preferably less than 0.5 seconds.

5. Method according to any of claims 1 to 5,
**characterised in that**
the stripping of the insulation of the aluminium wire portion and the subsequent bonding of the aluminium wire are carried out in direct temporal succession, there in particular being less than 300 seconds, preferably less than 30 seconds, between the stripping of the insulation of the aluminium wire portion being terminated and the aluminium wire being introduced to the ultrasound bonding.

6. Method according to any of claims 1 to 5,
**characterised in that**
the insulating varnish is removed from a plurality of aluminium wire portions simultaneously.

7. Method according to any of claims 1 to 6,
**characterised in that**
two aluminium wire portions of an aluminium wire are stripped of insulation simultaneously.

8. Method according to any of claims 1 to 7,
**characterised in that**
the aluminium wire is moved, and in particular introduced to a bonding tool, during the stripping of the insulation of the aluminium wire portion.

9. Method according to any of claims 1 to 8,
**characterised in that**
an action time for stripping the insulation of the aluminium wire portion is selected in such a way that the insulating varnish originally provided on the aluminium wire portion is at least 50 %, preferably at least 75 % and particularly preferably at least 85 % removed, and/or in such a way that at least 50 % of an outer face area of the aluminium wire portion, preferably more than 75 % of the outer face area of the aluminium wire portion and particularly preferably more than 85 % of the outer surface of the aluminium wire portion is freed from insulating varnish.

10. Method according to any of claims 1 to 9,
**characterised in that**
the action time for different aluminium wires and/or different insulating varnishes is determined in guiding preliminary tests and subsequently fixedly set in production operation.

11. Method according to any of claims 1 to 10,
**characterised in that**
during the stripping of the insulation of the aluminium wire portion a removal of varnish is detected and, taking account of the removal of varnish, the remaining action time is determined and/or a termination signal for the stripping of the insulation of the aluminium wire portion is generated.

12. Method according to any of claims 1 to 11,
**characterised in that**
a contact formed by the aluminium wire and the contact face is sealed, and in particular covered with a sheathing, after the ultrasound bonding.

## Revendications

1. Procédé de mise en contact électrique d'un fil d'aluminium sur une surface de contact, dans lequel le fil d'aluminium présentant une couche d'oxyde sur sa surface d'enveloppe est enveloppé avec un vernis isolant et est soudé par ultrason à la surface de contact, et dans lequel un segment de fil d'aluminium à appliquer sur la surface de contact pour la fabrication de la mise en contact électrique est dénudé avant le soudage par ultrason,
**caractérisé en ce**
**que** le vernis isolant entourant le fil côté enveloppe avec la couche d'oxyde est enlevé sous l'action d'un plasma électrique.

2. Procédé selon la revendication 1,
**caractérisé en ce**
**que** le plasma électrique est tempéré de manière définie et **en ce que** le plasma électrique présente de préférence une température de plus de 200 °C et de moins de 620 °C.

3. Procédé selon la revendication 1 ou 2,
**caractérisé en ce**
**que** pendant un fonctionnement en cadence, le segment de fil d'aluminium est d'abord dénudé et le fil d'aluminium est ensuite soudé par ultrason.

4. Procédé selon la revendication 3,
**caractérisé en ce**
**qu'**une cadence est inférieure à 10 secondes, de préférence inférieure à 1 seconde et de manière particulièrement préférée inférieure à 0,5 seconde.

5. Procédé selon l'une quelconque des revendications 1 à 4,
**caractérisé en ce**
**que** le dénudage du segment de fil d'aluminium et le soudage suivant par ultrason sont réalisés en se succédant directement temporellement, notamment moins de 300 secondes, de préférence moins de 30 secondes étant présentes entre l'achèvement du dénudage du segment de fil d'aluminium et l'amenée du fil d'aluminium pour le soudage par ultrason.

6. Procédé selon l'une quelconque des revendications 1 à 5,
**caractérisé en ce**
**que** simultanément, le vernis isolant est enlevé d'une pluralité de segments de fil d'aluminium.

7. Procédé selon l'une quelconque des revendications 1 à 6,
**caractérisé en ce**
**que** simultanément, deux segments de fil d'aluminium d'un fil d'aluminium sont dénudés.

8. Procédé selon l'une quelconque des revendications 1 à 7,
**caractérisé en ce**
**que** le fil d'aluminium est déplacé pendant le dénudage du segment de fil d'aluminium et est notamment amené à un outil de soudage.

9. Procédé selon l'une quelconque des revendications 1 à 8,
**caractérisé en ce**
**qu'**un temps d'action pour le dénudage du segment de fil d'aluminium est sélectionné de manière à ce que le vernis isolant ménagé initialement sur le segment de fil d'aluminium soit enlevé à au moins 50%, de préférence à moins 75% et de manière particulièrement préférée à au moins 85%, et/ou ce **en ce qu'**au moins 50% d'une surface latérale d'enveloppe du segment de fil d'aluminium, de préférence plus de 75% de la surface latérale d'enveloppe et de manière particulièrement préférée plus de 85% de la surface latérale d'enveloppe du segment de fil d'aluminium soient libérés du vernis isolant.

10. Procédé selon l'une quelconque des revendications 1 à 9,
**caractérisé en ce**
**que** le temps d'action pour différents fils d'aluminium et/ou différents vernis isolants est déterminé dans des essais préalables d'orientation et est ensuite prédéfini de manière fixe en fonctionnement de production.

11. Procédé selon l'une quelconque des revendications 1 à 10,
**caractérisé en ce**
**que** pendant le dénudage du segment de fil d'aluminium, un enlèvement de vernis est déterminé et **en ce qu'**en tenant compte de l'enlèvement de vernis, le temps d'action restant est déterminé et/ou un signal d'achèvement du dénudage du segment de fil d'aluminium est généré.

12. Procédé selon l'une quelconque des revendications 1 à 11,
**caractérisé en ce**
**qu'**un contact formé par le fil d'aluminium et la surface de contact est scellé après le soudage par ultrason et est notamment recouvert d'une enveloppe.
